# EUROPEAN PATENT APPLICATION

(11) **EP 2 699 019 A1**
(43) Date of publication of application: **19.02.2014**
(21) Application number: 12770803.0
(22) Date of filing: 12.03.2012
(51) Int. Cl.: H04R 3/00, H03F 3/68, H04R 3/14

(54) **DIGITAL SPEAKER SYSTEM**

(30) Priority: 15.04.2011 JP 2011090888
(71) Applicant: Clarion Co., Ltd., Saitama-shi, Saitama 330-0081 (JP)
(72) Inventor: TAKADA, Naoki, Saitama-shi, Saitama 330-0081 (JP); KONO, Kenji, Saitama-shi, Saitama 330-0081 (JP); TANAKA, Hiroyuki, Saitama-shi, Saitama 330-0081 (JP); UEHARA, Masayoshi, Saitama-shi, Saitama 330-0081 (JP)
(74) Representative: Glawe, Delfs, Moll
(86) International application number: PCT/JP2012/056294
(87) International publication number: WO 2012/140983

(57) **Abstract**

A digital speaker system that can perform both enhancement of reproduction capability and simplification of construction is provided with a construction using plural speaker units for one audio channel. The digital speaker system has a first signal processor 32A for generating plural driving digital signals SS1 to SS6 from one digital audio signal SB1 into which an input digital audio signal SA is branched, and a second signal processor 32B for generating a single driving digital signal SS7 from the other digital audio signal SB2 into which the input digital audio signal SA is branched, and a speaker unit for one audio channel is constructed by a main speaker unit 22A having a voice coil bobbin 23Awith plural voice coils suppliedwith the plural driving digital signals SS1 to SS6, and a sub speaker unit 22B having a voice coil bobbin 23B with a single voice coil supplied with the single driving digital signal.

## Description

### Technical Field

The present invention relates to a digital speaker system for driving a speaker on the basis of a digital audio signal.

### Background Art

There has been proposed a digital speaker system for converting a digital audio signal to plural digital signals (driving digital signals) and directly inputting the digital signals to plural voice coils to reproduce sounds (see Patent Document 1, for example).

In this digital speaker system, respective magnetic fields of the voice coils are added to one other to obtain a composite magnetic field, and a speaker unit is driven with the composite magnetic field. Therefore, reduction in power consumption and low-voltage driving can be implemented, and the sound quality can be enhanced.

### Prior Art

### Patent Document

Patent Document 1: JP-A-2009-71872

### Summary of the Invention

### Problem to be solved by the Invention

However, in this conventional construction, for example when a speaker unit used for one audio channel is configured as a 2-way system having a woofer for reproducing middle and low sound areas and a tweeter for reproducing a high sound area, two speaker units having the same construction must be prepared. In this case, each speaker has plural voice coils, and thus each vibrating system becomes heavy in weight. Particularly, with respect to the tweeter to which it is required that the diameter of the voice coils is small and the weight of the vibrating system is light, there occur a problem that the reproduction capability of the high sound area is lowered and manufacturing is very difficult. Furthermore, there is also a problem that the number of parts increases and the structure is complicated.

The present invention has been implemented in view of the foregoing situation, and has an object to provide a digital speaker system that can perform both of enhancement of reproduction capability and simplification of the construction in a construction using plural speaker units for one audio channel.

### Means of solving the Problem

In order to attain the above object, a digital speaker system according to the present invention comprises: a first signal processor that subjects a digital audio signal to ΔΣ modulation processing and processing of converting to plural driving digital signals to generate plural driving digital signals; a second signal processor that subjects the digital audio signal to ΔΣ modulation processing to generate a single driving digital signal; a first speaker unit having a voice coil bobbin with a plurality of voice coils supplied with the plural driving digital signals generated in the first signal processor; and a second speaker unit having a voice coil bobbin with a single voice coil supplied with the single driving digital signal generated in the second signal processor.

According to this construction, the first speaker unit has the voice coil bobbin having the plural voice coils supplied with the plural driving digital signals generated in the first signal processor. Therefore, high speaker driving force can be obtained. Furthermore, the second speaker unit has the voice coil bobbin having the single voice coil supplied with the single driving digital signal generated in the second signal processor. Therefore, a vibration system thereof can be made light in weight, and the number of parts can be reduced. Accordingly, both of enhancement of reproduction capability and simplification of the construction are made compatible with each other in the construction using the plural speaker units for one audio channel.

In the above construction, the second speaker unit may be a speaker unit that reproduces a higher sound area than the first speaker unit. According to this construction, the vibration system of the second speaker unit which is required to have a small voice coil diameter and a light vibration system can be made light in weight, and the number of parts can be reduced, so that both of enhancement of reproduction capability of a high sound area and simplification of the construction are compatible with each other.

In the above construction, the first signal processor may have a shaping circuit that performs shaping processing on the plural driving digital signals. According to this construction, the effect of dispersion of the plural voice coils of the first speaker unit on reproduced sounds can be suppressed.

In the above construction, a delay circuit that offsets a time lag in processing time between the first signal processor and the second signal processor may be further provided. According to this construction, both the speaker units can be synchronized with each other.

Furthermore, in the above construction, a first filter that limits a pass band to a signal component corresponding to a reproduction frequency band of the first speaker unit may be provided at a front stage of the first signal processor, and a second filter that limits a pass band to a signal component corresponding to a reproduction frequency band of the second speaker unit may be provided at a front stage of the second signal processor. According to this construction, the arithmetic operation amounts of the first and second signal processors can be reduced, and the processing loads imposed on the respective signal processors can be reduced.

Still furthermore, in the above construction, a noise removing capacitor may be disposed between the second signal processor and the second speaker unit. According to this construction, it is unnecessary to provide many noise removing capacitors, and the construction can be made advantageous to high sound quality with suppressing the cost.

### Effect of the Invention

According to the present invention, both of enhancement of reproduction capability and simplification of the construction are compatible with each other in the construction using the plural speaker units for one audio channel.

### Brief Description of the Drawings

[Fig. 1] Fig. 1 is a diagram showing the electrical construction of a digital speaker system according to a first embodiment.
[Fig. 2] Fig. 2 is a block diagram showing a first signal processor.
[Fig. 3] Fig. 3 is a diagram showing the electrical construction of a digital speaker system according to a second embodiment.
[Fig. 4] Fig. 4 is a diagram showing the electrical construction of a digital speaker system according to a third embodiment.

### Best Modes for carrying out the Invention

Embodiments according to the present invention will be described hereunder with reference to the drawings.

### <First Embodiment>

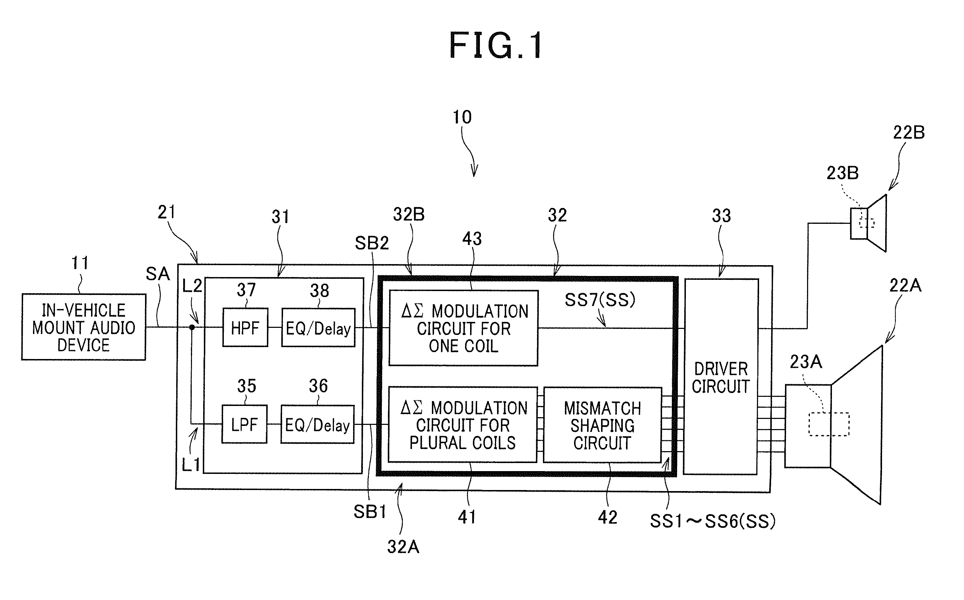

Fig. 1 is a diagram showing the electrical construction of a digital speaker system according to a first embodiment.

The digital speaker system 10 is applied to an in-vehicle mount speaker system mounted in a vehicle, for example, and it is supplied with a digital audio signal output from an in-vehicle mount audio device (an audio output device such as a CD player, a car navigation device or the like) 11 mounted in a vehicle, and outputs corresponding sounds into the interior of the vehicle. In general, speaker systems whose number corresponds to a channel number equal to 2 channels at the right and left sides, 5.1 channels (6 channels) or more channels are mounted in a vehicle, and for example, a digital speaker system 10 shown in Fig. 1 is applied to each audio channel at the front side while a digital speaker system of a single speaker unit is applied to the other audio channels.

This digital speaker system 10 has a signal processing device 21 for executing various kinds of signal processing on a digital audio signal SA output from the in-vehicle audio device 11 to generate driving digital signals and outputting the driving digital signals, and a main speaker unit 22A and a sub speaker unit 22B which are driven by the driving digital signals SS output from the signal processing device 21.

The main speaker unit 22A is a woofer for reproducing middle and low sound areas, and the sub speaker unit (the sub speaker unit for reproducing a high sound area) 22B is a tweeter for reproducing the high sound area. That is, this embodiment adopts a 2-way system which covers the sound area by the two speaker units 22A and 22B, and it is more advantageous in sound quality, etc. as compared with a 1-way system which covers the sound area by a single full-range speaker.

The main speaker unit 22A is a plural-voice-coil speaker (first speaker unit) having a voice coil bobbin 23A with plural (six in this embodiment) voice coils. A driving digital signal is supplied to each voice coil, and magnetic fields formed by the plural voice coils are added to one another, whereby sufficient speaker driving force can be obtained. A publicly known speaker disclosed in JP-A-2009-71872 or the like is broadly applicable to this plural-voice-coil speaker.

The sub speaker unit 22B is a speaker unit (second speaker unit) having a voice coil bobbin 23B having a single voice coil, and it has the same construction as a general voice coil speaker except that it is driven with a digital audio signal SA.

The signal processing device 21 has a signal input unit 31 supplied with a digital audio signal SA output from the in-vehicle mount audio device 11, a signal processor 32 for generating driving digital signals SS from output signals (digital audio signals) SB1, SB2 of the signal input unit 31, and a driver circuit 33 for driving the main speaker unit 22A and the sub speaker unit 22B on the basis of the driving digital signals SS.

As shown in Fig. 1, an input line connected to the signal input unit 31 is branched into two lines, and the same digital audio signal SA is input to the signal input unit 31 through two systems. The signal processor 32 and the driver circuit 33 are independently provided with a signal line for the main speaker (hereinafter referred to as first signal line L1) and a signal line for the sub speaker (hereinafter referred to as second signal line L2).

The signal input unit 31 has a low-pass filter (LPF) 35 as a first filter and a first signal adjusting circuit (EQ/Delay) 36 on the first signal line L1, and a high-pass filter (HPF 37 as a second filter and a second signal adj usting circuit (EQ/Delay) 38 on the second signal line L2.

The low-pass filter 35 cuts off a signal component of the high sound area from the digital audio signal SA, whereby signal components of the middle and low sound areas corresponding to a reproduction frequency band of the main speaker unit 22A are allowed to pass through the low-pass filter 35. The first signal adjusting circuit 36 is an equalizer/delay circuit for the main speaker, and performs change of a preset audio frequency characteristic (adjustment of sound quality) and delay.

The high-pass filter 37 cuts off the signal components of the middle and low sound areas from the digital audio signal SA, whereby the signal component of the high sound area corresponding to the reproduction frequency band of the sub speaker unit 22B is allowed to pass through the high-pass filter 37. The second signal adjusting circuit 38 is an equalizer/delay circuit for the sub speaker, and performs change of the preset audio frequency characteristic (adjustment of sound quality) and delay.

In this embodiment, the sound quality adjustment matched with the main speaker unit 22A is performed by the equalizer function of the first signal adjustment circuit 36, and the sound quality adjustment matched with the sub speaker unit 22B is performed by the equalizer function of the second signal adjustment circuit 38. Accordingly, the sound quality adjustment corresponding to the inherent characteristic of each of the speaker units 22A, 22B can be independently performed.

Furthermore, the delay function of the first and second signal adjusting circuits 36, 38 is used to synchronize the audio output timing between both the speaker units 22A and 22B. Specifically, according to this embodiment, since the signal processing is independently performed between the first signal line L1 and the second signal line L2, a time lag occurs in the signal processing time between the lines L1 and L2. Particularly, in the signal processor 32, the processing time of the first signal line L1 is longer by the amount corresponding to a mismatch shaping circuit 42 described later, and thus the signal processing time of the first signal line L1 is longer than the second signal line L2. Therefore, the delay time of the second signal adjusting circuit 38 in the signal input unit 31 is set to be longer than that of the first signal processing circuit 36 so as to nullify thetimelag (difference) in signal processing time. Accordingly, the time lag of the signal processing time in the signal processor 32 is offset, and both the speaker units 22a and 22B are synchronized with each other.

Next, the signal processor 32 will be described.

The signal processor 32 is constructed by an arithmetic processing circuit for performing various kinds of arithmetic processing, and it roughly has a first signal processor 32A provided on the first signal line L1 and a second signal processor 32 provided on the second signal line L2.

The first signal processor 32A is configured to have a ΔΣ (delta sigma) modulation circuit 41 for plural coils and a mismatch shaping circuit 42, and the second signal processor 32B is configured to have a ΔΣ modulation circuit 43 for one coil.

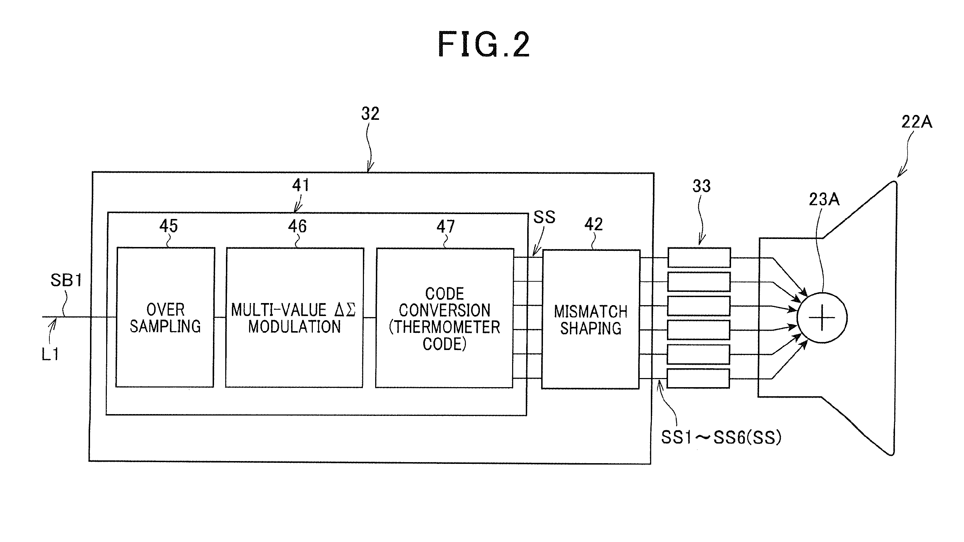

Fig. 2 is a block diagram showing the first signal processor 32A.

The ΔΣ modulation circuit 41 for plural coils serves to perform ΔΣ (delta sigma) modulation processing on the digital audio signal (first digital audio signal) SB1 of the first signal line L1, and it has an over-sampling unit 45, a multi-value Δ Σ modulator 46 and a code converter 47 as shown in Fig. 2. The digital audio signal SB1 of the first signal line L1 is over-sampled by the over-sampling unit 45, whereby a re-quantized noise distribution is distributed in a broad area, and then subjected to ΔΣ modulation by the multi-value ΔΣ modulator 46 to shape the re-quantized noise. Thereafter, the code converter 47 converts the multi-value bit output of the multi-value ΔΣ modulator 46 to a thermometer code of N bits corresponding to the number of the voice coils, and outputs the thus-converted thermometer code.

The conversion to the thermometer code generate plural (six in this embodiment) driving digital signals SS1 to SS6 (SS) which correspond to the plural voice coils and can directly drive the main speaker unit 22a with digital signals.

A ΔΣ modulation circuit disclosed in JP-A-2009-71872 is applied to this ΔΣ modulation circuit 41 for plural coils. However, the present invention is not limited to this modulation circuit, and other publicly known ΔΣ modulation circuits used for DA conversion or the like may be applied.

Here, when the plural driving digital signals SS output from the code converter 47 are supplied to the driver circuit 33 to drive the main speaker unit 22A, the dispersion of the plural voice coils of the main speaker unit 22A (dispersion of impedance or the like) has an adverse effect on reproduced sounds.

In this construction, the mismatch shaping circuit 42 is provided at the output side of the code converter 47, and the mismatch shaping circuit 42 can suppress the adverse effect of the dispersion of the plural voice coils or noise on the reproduced sounds by executing the mismatch shaping processing on the plural driving digital signals SS output from the code converter 47. A publicly known mismatch shaping circuit is broadly applicable to the mismatch shaping circuit 42.

The ΔΣ modulation circuit 43 for one coil (see Fig. 1) executes the ΔΣ (digital sigma) modulation processing on the digital audio signal (second digital audio signal) SB2 of the second signal line L2. The ΔΣ modulation circuit 43 for one coil is different from the ΔΣ modulation circuit 41 for plural coils in that the driving digital signal SS7 (SS) corresponding to a single voice coil is generated, and is substantially identical to the ΔΣ modulation circuit 41 for plural coils in the other points.

The driving digital signal SS7 output from the ΔΣ modulation circuit 43 for one coil is supplied to the driver circuit 33, and supplied to drive the sub speaker unit 22B. The sub speaker unit 22B has only the single voice coil, and thus it does not have any dispersion of plural voice coils which exists in the main speaker unit 22A. Therefore, the mismatch shaping circuit is unnecessary in the ΔΣ modulation circuit 43 for one coil.

That is, as compared with the ΔΣ modulation circuit 41 for plural coils, the processing of generating the plural driving digital signals SS and the mismatch shaping processing are omitted in the ΔΣ modulation circuit 43 for one coil, and the construction thereof is simpler than that of the ΔΣ modulation circuit 43 for plural coils.

Comparing the main speaker unit 22A and the sub speaker unit 22B, a higher operation speed is required to the sub speaker unit 22B for reproducing the high sound area as compared with the main speaker unit 22A for reproducing the middle and low sound areas whereas the driving energy required to the sub speaker unit 22B is remarkably smaller. Inotherwords, remarkablyhigher driving energy is required to the main speaker unit 22A for reproducing the middle and low sound areas to secure sufficient sound pressure as compared with the sub speaker unit 22B.

In this construction, the main speaker unit 22A is constructed by a voice coil speaker having plural voice coils, and the plural driving digital signals SS1 to SS6 are supplied to all the voice coils to drive the voice coils. Therefore, the magnetic fields formed by the plural voice coils are added to one another, whereby high speaker driving force can be obtained. Accordingly, sufficient driving energy can be secured for reproduction of the middle and low sound areas.

Furthermore, in this construction, the sub speaker unit 22B comprises a voice coil speaker having a single voice coil, and the voice coil is supplied with the driving digital signal SS7 to be driven. Therefore, the voice coil bobbin 23B having the voice coil can be constructed to be light in weight by a small number of parts with satisfying sufficient speaker driving force for reproduction of the high sound area.

Accordingly, the vibrating system of the sub speaker unit 22B used for the digital speaker system 10 can be reduced in weight, the reproduction capability of the high sound area can be enhanced, and the number of parts can be reduced. Accordingly, the construction can be simplified with enhancing the reproduction capability, manufacturing can be facilitated, and the cost can be reduced.

As described above, according to this embodiment, the digital speaker system 10 in which the speaker units are driven with the driving digital signals SS generated by subjecting the digital audio signal SA to ΔΣ modulation processing is provided with the first signal processor 32A for generating the plural driving digital signals SS1 to SS6 from one digital audio signal SB1 into which the digital audio signal SA is branched, and the second signal processor 32B for generating the single driving digital signal SS7 from the other digital audio signal SB2 into which the digital audio signal SA is branched. Furthermore, the speaker unit corresponding to one audio channel is constructed by the main speaker unit (first speaker unit) 22A having the voice coil bobbin 23A with the plural voice coils supplied with the plural driving digital signals SS1 to SS6, and the sub speaker unit (second speaker unit) 22B having the voice coil bobbin 23B with the single voice coil supplied with the single driving digital signal SS7. The vibrating system of the sub speaker unit 22B can be designed to be light in weight and the number of parts can be reducedwhile the sufficient speaker driving force required to both the speaker units 22A, 22B can be secured. The enhancement of the reproducing capability and the simplification of the construction are compatible with each other. Accordingly, the low-cost digital speaker system 10 having high sound quality can be implemented.

In addition, the sub speaker unit 22B comprises a tweeter which reproduces a higher sound area than the main speaker unit 22A, and the tweeter is required to have a small voice coil diameter and a vibrating system of light weight. Therefore, these requirements can be satisfied. Accordingly, both the enhancement of the reproduction capability of the higher sound area and the simplification of the construction are compatible with each other.

Furthermore, the first signal processor 32A has the mismatch shaping circuit 42 for executing the mismatch shaping processing on the plural driving digital signals SS1 to SS6. Therefore, reproduced sounds can be suppressed from being adversely affected by the dispersion of the plural voice coils of the main speaker unit 22A. Furthermore, the second signal processor 32B has no mismatch shaping circuit, and thus the construction of the second signal processor 32B can be simplified.

Still furthermore, there are provided the signal adjusting circuits 36, 38 functioning as the delay circuits for offsetting the time lag in processing time between the first signal processor 32A and the second signal processor 32B. Therefore, even in the construction that the first signal processor 32A and the second signal processor 32B have different signal processing times because the first signal processor 32A has the mismatch shaping circuit 42 whereas the second signal processor 32B has no mismatch shaping circuit, etc., both the speaker units 22A and 22B can be synchronized with each other.

In this construction, the two signal adjusting circuits 36, 38 functioning as the delay circuits are provided. However, in short, it is merely required that the signal at the second signal processor 32B side having a shorter processing time is delayed, and only the second adjusting circuit 38 may be provided. Furthermore, the positions of the signal adjusting circuits 36, 38 may be properly changed.

Furthermore, in this construction, the low-pass filter (first filter) 35 for limiting the pass band to the signal component corresponding to the reproduction frequency band of the main speaker unit 22A is provided at the front stage of the first signal processor 32A, and the high-pass filter (second filter) 37 for limiting the pass band to the signal component corresponding to the reproduction frequency band of the sub speaker unit 22B is provided at the front stage of the second signal processor 32B. Therefore, the arithmetic operation amounts at the first signal processor 32A and the second signal processor 32B can be reduced, and the processing loads imposed on the respective signal processors 32A, 32B can be reduced.

### <Second Embodiment>

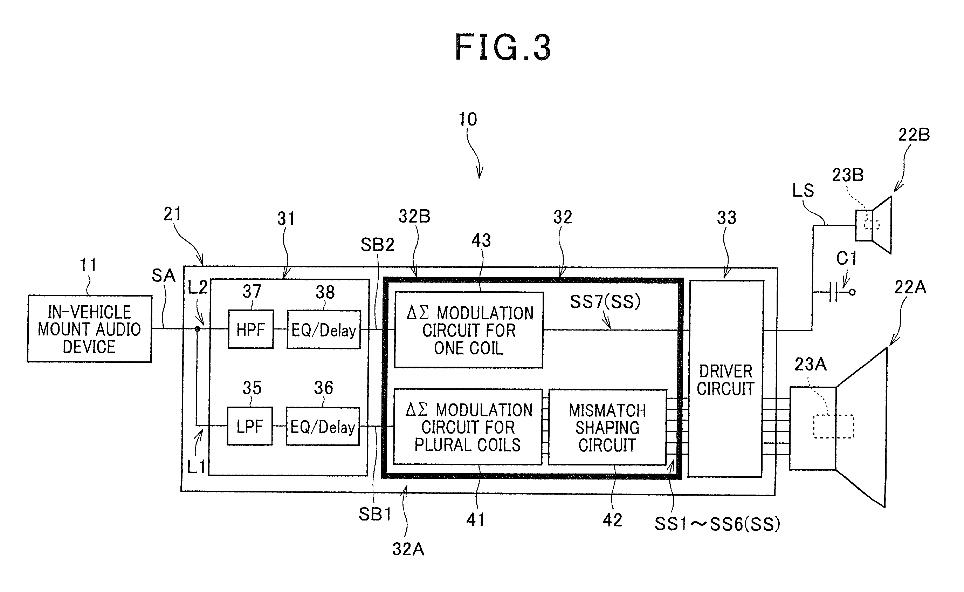

Fig. 3 shows a second embodiment. In the second embodiment, a capacitor C1 for removing noise is provided between the second signal processor 32B and the sub speaker unit (second speaker unit) 22B. This capacitor C1 is provided between a ground line (not shown) and a signal line LS between the second signal processor 32B and the sub speaker unit 22B, and removes high-frequency noise components to enhance the reproduction capability of the high sound area.

In the conventional digital speaker system having plural voice coils, many signal lines for connecting the signal processor to the respective voice coils of the speaker unit exist. Therefore, when the capacitor C1 for removing noise as described above is adopted, capacitors C1 whose number is equal to the number of the signal lines are necessary. Therefore, the number of parts increases, resulting in increase of the cost.

On the other hand, according to the construction of this embodiment, with respect to the sub speaker unit 22B, it is provided with the single voice coil, and thus it is unnecessary to provide many capacitors C1 for removing noise. Therefore, the digital speaker system can be configured to be advantageous to reproduction of the high sound area with suppressing the cost.

A coil may be added to the signal line LS so that an LC filter for removing noise is constructed by the coil and the capacitor C1. Furthermore, in place of the LC filter, another publicly known noise removing filter may be applied.

### <Third Embodiment>

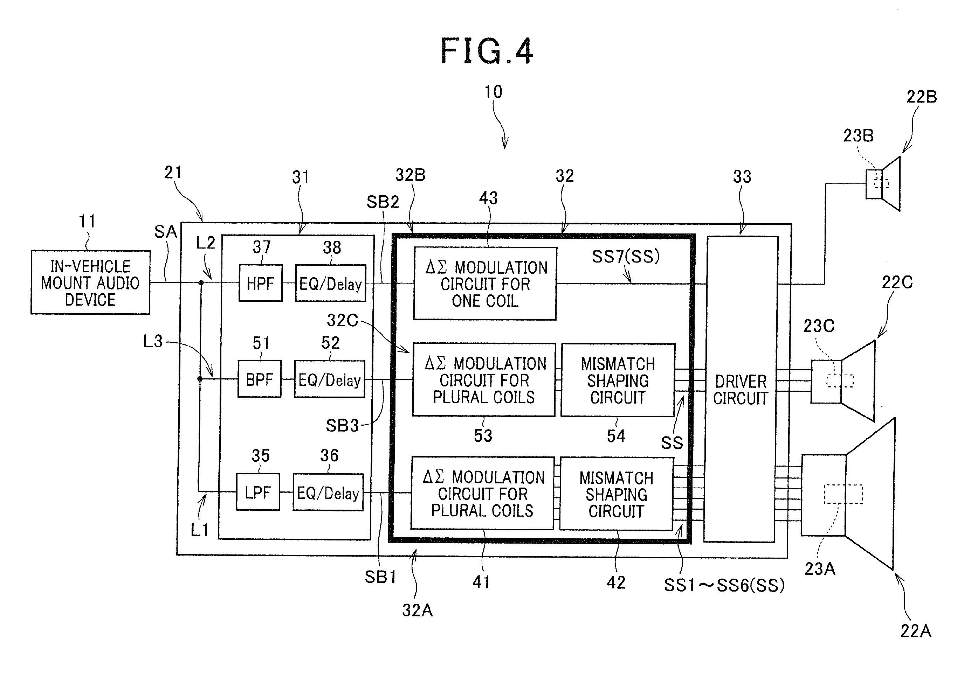

Fig. 4 shows a third embodiment. In the third embodiment, the digital speaker system is applied to a 3-way speaker system. The digital speaker system of this embodiment has a high-area speaker unit (corresponding to a tweeter) 22B for reproduction of a high sound area, a middle-area speaker unit (corresponding to a squawker) 22C for reproducing a middle sound area, and a low-area speaker unit (corresponding to a woofer) 22A for reproducing a low sound area.

The high-area speaker unit 22B and the its peripheral construction are substantially the same as the sub speaker unit 22B and its peripheral construction of the above embodiment, and the low-area speaker unit 22A and its peripheral circuit are substantially the same as the main speaker unit 22A and its peripheral circuit of the above embodiment. Therefore, these elements are represented by the same reference numerals, and the duplicative descriptions thereof are omitted. With respect to the other constructions, the same constructions as the above embodiment are represented by the same reference numerals, and the duplicative descriptions thereof are omitted. The different portions will be described hereunder in detail.

The middle-area speaker unit 22C is constructed as a plural-voice-coil speaker (first speaker unit) having a voice coil bobbin 23C with plural (three in this embodiment) voice coils.

In the signal processing device 21, the input line connected to the signal input unit 31 is branched into three lines, and the same digital audio signal SA is input to the signal input unit 31 through three systems. The signal input unit 31, the signal processor 32 and the driver circuit 33 are independently provided with first signal line L1 corresponding to the low-area speaker unit 22A, the second signal line L2 corresponding to the high-area speaker unit 22B and the third signal line L3 corresponding to the middle-area speaker unit 22C.

In the signal input unit 31, a band pass filter (BPF) 51 and a third signal adjusting circuit (EQ/delay) 52 are provided to the third signal line L3. The pass band is limited to the signal component corresponding to the reproduction frequency band of the middle-area speaker unit 22C by the band pass filter 51, and the change (sound quality adjustment) of the preset audio frequency characteristic and delay are performed by the third signal adjusting circuit 52. In this case, the third signal adjusting circuit 52 performs the sound quality adjustment matched with the middle-area speaker unit 22C and also sets the delay amount so that all the speaker units 22A to 22C are synchronized with one another.

The low pass filter 35 of the second signal line L2 passes only the signal component of the low sound area corresponding to the reproduction frequency band of the low-area speaker unit 22A.

In the signal processor 32, the third signal line L3 is provided with the third signal processor 32C, and the third signal processor 32C is configured to have an ΔΣ (delta sigma) modulation circuit 53 for plural coils and a mismatch shaping circuit 54.

The ΔΣ modulation circuit 53 for plural coils executes ΔΣ modulation processing on the digital audio signal (third digital audio signal) of the third signal line L3. The ΔΣ modulation circuit 53 for plural coils is different from the ΔΣ modulation circuit 41 for plural coils of the first signal line L1 in that three driving digital signals SS are generated although six driving digital signals SS are generated in the ΔΣ modulation circuit 41 for plural coils, and is identical to the ΔΣ modulation circuit 41 for plural coils in the other points.

Furthermore, with respect to the mismatch shaping circuit 54, it is different from the mismatch shaping circuit 42 of the first signal line L1 in that the mismatch shaping processing is executed on the three driving digital signals SS although the mismatch shaping processing is executed on the six driving digital signals SS in the mismatch shaping circuit 42, and is identical to the mismatch shaping circuit 42 in the other points.

The driving digital signals SS output from the mismatch shaping circuit 54 are supplied through the driver circuit 33 to the respective voice coils of the middle-area speaker unit 22C, and the magnetic fields formed by the respective voice coils are added to one other to obtain high speaker driving force.

As described above, according to the construction of this embodiment, the number of voice coils of the speaker unit decreases as the reproduction frequency band of the speaker unit is higher. Therefore, the vibration system of the speaker unit can be made lighter in weight as the reproduction frequency band of the speaker unit is higher, and the high operation speed required to the speaker unit can be satisfied as the reproduction frequency band of the speaker unit is higher. Furthermore, the speaker unit is driven by a larger number of voice coils as the reproduction frequency band of the speaker unit is lower. Therefore, the driving energy required to the speaker unit can be satisfied as the reproduction frequency band of the speaker unit is lower.

As described above, according to the construction of this embodiment, the numbers of voice coils of the speaker units 22A to 22C are changed in accordance with the frequency band and the driving energy. Therefore, the operation speed and the driving energy which are required to each of the speaker units 22A to 22C can be satisfied.

In general, the voice coil diameter of the speaker unit is smaller as the reproduction frequency band of the speaker unit is higher. However, according to the construction of this embodiment, the number of voice coils of the speaker unit is smaller as the reproduction frequency band of the speaker unit is higher. Therefore, the construction can be simplified, and manufacturing can be facilitated.

The embodiments described above are merely examples of the present invention, and any modification may be made within the scope of the present invention. For example, in the above embodiments, the present invention is applied to the 2-way or 3-way digital speaker system. However, the present invention is not limited to these digital speaker systems. For example, the present invention may be applied to a 4-way digital speaker system. In short, the present invention is broadly applicable to a digital speaker system in which plural speaker units are used for one audio channel. Furthermore, the present invention is applicable to a digital speaker system other than the in-vehicle mount speaker system.

Furthermore, in the above embodiments, the mismatch shaping circuit 42 is provided. However, the present invention is not limited to this mismatch shaping circuit, and another shaping circuit such as a noise shaping circuit or the like maybe provided.

### Description of Reference Numerals

- 10: digital speaker system
- 11: in-vehicle mount audio device
- 21: signal processing device
- 22A: main speaker unit (low-area speaker unit, first speaker unit)
- 22B: sub speaker unit (high-area speaker unit, second speaker unit)
- 22C: middle-area speaker unit (first speaker unit)
- 23A to 23C: voice coil bobbin
- 31: signal input unit
- 32: signal processor
- 33: driver circuit
- 35: low pass filter (first filter)
- 36: first signal adjusting circuit (equalizer/delay circuit)
- 37: high pass filter (second filter)
- 38: second signal adjusting circuit (equalizer/delay circuit)
- 41, 53: ΔΣ modulation circuit for plural coils
- 42, 54: mismatch shaping circuit
- 43: ΔΣ modulation circuit for one coil
- C1: capacitor
- SA, SB1 to SB3: digital audio signal
- SS: driving digital signal

## Claims

1. A digital speaker system, comprising:
a first signal processor that performs ΔΣ modulation processing and processing of converting to plural driving digital signals on a digital audio signal to generate plural driving digital signals;
a second signal processor that performs ΔΣ modulation processing on the digital audio signal to generate a single driving digital signal;
a first speaker unit having a voice coil bobbin with a plurality of voice coils supplied with the plural driving digital signals generated in the first signal processor; and
a second speaker unit having a voice coil bobbin with a single voice coil supplied with the single driving digital signal generated in the second signal processor.

2. The digital speaker system according to claim 1, wherein the second speaker unit is a speaker unit that reproduces a higher sound area than the first speaker unit.

3. The digital speaker system according to claim 1 or 2, wherein the first signal processor has a shaping circuit that performs shaping processing on the plural driving digital signals.

4. The digital speaker system according to claim 3, further comprising a delay circuit that offsets a time lag in processing time between the first signal processor and the second signal processor.

5. The digital speaker system according to any one of claims 1 to 4, further comprising a first filter that limits a pass band to a signal component corresponding to a reproduction frequency band of the first speaker unit and is provided at a front stage of the first signal processor, and a second filter that limits a pass band to a signal component corresponding to a reproduction frequency band of the second speaker unit and is provided at a front stage of the second signal processor.

6. The digital speaker system according to any one of claims 1 to 5, wherein a noise removing capacitor is disposed between the second signal processor and the second speaker unit.
